(19) Europäisches Patentamt / European Patent Office / Office européen des brevets

(11) **EP 4 478 612 A1**

(12) **EUROPÄISCHE PATENTANMELDUNG**

(43) Veröffentlichungstag:
**18.12.2024 Patentblatt 2024/51**

(21) Anmeldenummer: 23179501.4

(22) Anmeldetag: **15.06.2023**

(51) Internationale Patentklassifikation (IPC):
**H03K 17/0812** (2006.01)  **H03K 17/082** (2006.01)
**H03K 17/16** (2006.01)

(52) Gemeinsame Patentklassifikation (CPC):
**H03K 17/168; H03K 17/08128; H03K 17/0828;**
H03K 2217/0027

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(71) Anmelder: **Siemens Aktiengesellschaft**
**80333 München (DE)**

(72) Erfinder: **Neumeister, Matthias**
**91058 Erlangen (DE)**

(74) Vertreter: **Siemens Patent Attorneys**
**Postfach 22 16 34**
**80506 München (DE)**

(54) **TREIBERSCHALTUNG UND VERFAHREN ZUR ANSTEUERUNG EINES HALBLEITERSCHALTERS**

(57) Es wird eine Treiberschaltung und ein Verfahren zur Ansteuerung eines Halbleiterschalters angegeben, bei denen im Zuge eines Abschaltvorgangs des Halbleiterschalters ein erster Messwert für die Zeitspanne vom Beginn des Abschaltvorgangs bis zum Erreichen eines festlegbaren Schwellwerts der Kollektor-Emitter-Spannung ermittelt wird, ein zweiter Messwert für eine im Zuge des Abschaltvorgangs auftretende maximale über den Halbleiterschalter abfallende Spannung ermittelt wird, ein Wertepaar aus dem ersten und zweiten Messwert wenigstens bis zu einem folgenden Abschaltvorgang gespeichert wird, für einen folgenden Abschaltvorgang aus dem Wertepaar eine Bewertungsgröße ermittelt wird und basierend auf der Bewertunsgrö-$\beta$e eine Steuermaßnahme zur Verringerung der zeitlichen Änderung des durch den Halbleiterschalter fließenden Stroms vorzunehmen.

FIG 6

EP 4 478 612 A1

**Beschreibung**

Beim Ausschalten von Halbleiterschaltern wie IGBTs treten aufgrund von angeschlossenen Induktivitäten Ausschaltüberspannungen auf. Bei den angeschlossenen Induktivitäten kann es sich sowohl um induktive Bauelemente wie auch um Streuinduktivitäten, also parasitäre Elemente wie beispielsweise Leitungsinduktivitäten handeln. Die sich ergebenden Ausschaltüberspannungen können höher als die maximal zulässige Sperrspannung des Halbleiterschalters sein und damit seine Lebensdauer verringern oder ihn im Extremfall sogar direkt zerstören.

Da die Höhe der Ausschaltüberspannungen unter anderem von der Geschwindigkeit des Abschaltens beeinflusst wird, fallen die Ausschaltüberspannungen bei neueren IGBT-Generationen stärker ins Gewicht, da diese Bauelemente auf schnelleres Schalten ausgelegt werden. Schnelles Schalten wird dabei generell bevorzugt, da damit die auftretenden Schaltverluste verringert werden.

Es ist bekannt, zu hohe Ausschaltüberspannungen anhand der zeitlichen Ableitung des Kollektorstroms ($dI_C/dt$) oder anhand der zeitlichen Ableitung der Spannung über den Halbleiterschalter (Kollektor-Emitter-Spannung ($dU_{CE}/dt$)) zu detektieren. Diese Detektion kann direkt in der Treiberschaltung des Halbleiterschalters erfolgen und Gegenmaßnahmen wie ein zeitweises Wiedereinschalten des Halbleiterschalters können ebenfalls direkt dort getroffen werden. Dadurch werden die Gegenmaßnahmen schnell umgesetzt. Bei früheren Generationen von IGBTs war dadurch eine ausreichende Reaktionsgeschwindigkeit verfügbar, um in der verbleibenden Zeit von - grob - 1 μs nach einer der beschriebenen Messmethoden eine Gegenmaßnahme einzuleiten und eine Beschädigung des Halbleiterschalters zu verhindern.

Bei modernen Halbleiterschaltern ist aber bedingt durch deren hohe Schaltgeschwindigkeit die nach einer der oben beschriebenen Messmethoden verbleibende Zeit, um Gegenmaßnahmen einzuleiten, kürzer als bisher und kann im Bereich von weniger als 100 ns liegen. Diese Zeit kann selbst bei einer Reaktion in der Treiberschaltung zu gering sein, um sicher eine Beschädigung des Halbleiterschalters ausschließen zu können. Als generelle Gegenmaßnahme kann das Ausschalten zwar unabhängig von der konkreten Situation des Halbleiterschalters verzögert werden, das ist aber sehr unattraktiv, da damit der Vorteil des schnellen Schaltens, nämlich die Verringerung der Schaltverluste, negiert wird.

Es ist Aufgabe der vorliegenden Erfindung, eine Treiberschaltung für einen Halbleiterschalter anzugeben, die die eingangs genannten Nachteile vermeidet, also eine verbesserte Reaktion auf eine möglicherweise zu hohe Ausschaltspannung ermöglicht. Eine weitere Aufgabe besteht darin, ein entsprechendes Verfahren zur Ansteuerung eines Halbleiterschalters anzugeben.

Diese Aufgabe wird durch eine Treiberschaltung mit den Merkmalen von Anspruch 1 gelöst. Hinsichtlich des Verfahrens besteht eine Lösung in dem Verfahren mit den Merkmalen von Anspruch 14.

Die erfindungsgemäße Treiberschaltung zur Ansteuerung eines Halbleiterschalters umfasst einen Kontakt zur Verbindung mit einem Steueranschluss (Gate-Anschluss) des Halbleiterschalters. Sie umfasst weiterhin eine Vorrichtung in Form einer Schaltung, die ausgestaltet ist, im Zuge eines Abschaltvorgangs des Halbleiterschalters eine Messung eines von der Höhe des durch den Schalter fließenden Stroms abhängigen Werts vorzunehmen. Je nach konkretem Halbleiterschalter ist der durch den Schalter fließende Strom der Kollektorstrom oder der Drainstrom.

In einer ersten Alternative ist dieser Wert die Höhe des Gatestroms zu einem Zeitpunkt nach Beginn des Abschaltvorgangs.

In einer zweiten Alternative ist dieser Wert eine Zeitspanne vom Beginn des Abschaltvorgangs bis zum Erreichen eines festlegbaren Schwellwerts der über den Halbleiterschalter abfallenden Spannung. Je nach konkretem Halbleiterschalter wird die Spannung als Kollektor-Emitter-Spannung oder Source-Drain-Spannung bezeichnet.

Die Vorrichtung ist ferner ausgestaltet, einen zweiten Messwert für eine im Zuge des Abschaltvorgangs auftretende maximale über den Halbleiterschalter abfallende Spannung aufzunehmen.

Die Vorrichtung ist ausgestaltet, für einen folgenden Abschaltvorgang unter Verwendung des ersten und zweiten Messwerts eine Bewertungsgröße zu ermitteln und basierend auf der Bewertungsgröße eine Steuermaßnahme zur Verringerung der zeitlichen Änderung des durch den Halbleiterschalter fließenden Stroms vorzunehmen. Dabei ist mit der Verringerung eine Verringerung des Betrags der zeitlichen Änderung gemeint, also eine Verlangsamung der Strom-Änderung unabhängig von ihrer Richtung.

Bei dem erfindungsgemäßen Verfahren zur Ansteuerung eines Halbleiterschalters wird im Zuge eines Abschaltvorgangs des Halbleiterschalters eine Messung eines von der Höhe des Kollektorstroms abhängigen Werts vorgenommen. In einer ersten Alternative ist dieser Wert die Höhe des Gatestroms zu einem Zeitpunkt nach Beginn des Abschaltvorgangs. In einer zweiten Alternative ist dieser Wert eine Zeitspanne vom Beginn des Abschaltvorgangs bis zum Erreichen eines festlegbaren Schwellwerts der Kollektor-Emitter-Spannung.

Weiterhin wird ein zweiter Messwert für eine im Zuge des Abschaltvorgangs auftretende maximale über den Halbleiterschalter abfallende Spannung aufgenommen, für einen folgenden Abschaltvorgang mit dem ersten und zweiten Messwert eine Bewertungsgröße ermittelt wird und basierend auf der Bewertungsgröße eine Steuermaßnahme zur Verringerung der zeitlichen Änderung des durch den Halbleiterschalter fließenden Stroms vorgenommen wird.

Es ist zweckmäßig, ein Wertepaar aus dem ersten und zweiten Messwert wenigstens bis zu einem folgenden

EP 4 478 612 A1

Abschaltvorgang zu speichern.

Vorteilhaft liegen die Zeitpunkte, zu denen mit dem erfindungsgemäßen Verfahren und der erfindungsgemäßen Treiberschaltung eine Messung vorliegt, die eine Aussage über das Auftreten einer zu großen Abschalt-Überspannung vorliegt, deutlich vor denjenigen, die mit anderen bekannten Methoden erreichbar sind. Beispielsweise kann die $dU_{CE}/dt$-Messung erst etwa dann erfolgen, wenn die Kollektor-Emitter-Spannung schon auf etwa die Hälfte der Nennspannung angestiegen ist. Dagegen kann in der zweiten Alternative der Schwellwert auf einen deutlich geringeren Wert festgelegt werden.

Die Erfindung ermöglicht also eine deutlich frühere Erkennung eines hohen Kollektor-Stroms und erlaubt daher auch bei sehr schnell schaltenden Halbleiterschaltern eine Reaktion auf einen zu hohen Kollektor-Strom.

Weiterhin ist vorteilhaft, dass durch die Bestimmung der Bewertungsgröße unter Verwendung des zweiten Messwertes erkannt werden kann, wie stark das Eingreifen in den Abschaltvorgang sein muss, speziell im normalen Betrieb, also ohne vorliegenden Fehler. Vorteilhaft ist dabei eine Kalibrierung auf die Eigenschaften des spezifischen Halbleiterschalters unnötig. Die Exemplarstreuung der Halbleiterschalter könnte ansonsten dazu führen, dass die Treiberschaltung an den einzelnen Schalter angepasst werden muss. Auch der Einfluss anderer Störgrößen wie beispielsweise der Temperatur ist unerheblich, selbst wenn dieser Einfluss erheblich oder sogar überwiegend ist gegenüber dem Einfluss des Kollektor-Stroms auf die gemessenen Werte. Voraussetzung ist, dass die Störgrößen nur eine geringfügige Veränderung zwischen zwei aufeinanderfolgenden Abschaltvorgängen aufweisen. Da aber die Abschaltvorgänge mit Frequenzen von 10 kHz oder mehr aufeinander folgen, ist das für die Temperatur erfüllt.

Vorteilhafte Ausgestaltungen der erfindungsgemäßen Treiberschaltung und des erfindungsgemäßen Verfahrens gehen aus den von Anspruch 1 abhängigen Ansprüchen hervor. Dabei kann die Ausführungsform nach Anspruch 1 mit den Merkmalen eines der Unteransprüche oder vorzugsweise auch mit denen aus mehreren Unteransprüchen kombiniert werden. Demgemäß können noch zusätzlich folgende Merkmale vorgesehen werden:
Die Vorrichtung kann ausgestaltet sein, für zwei oder mehr, insbesondere aufeinanderfolgende, Abschaltvorgänge Wertepaare aus einem jeweiligen ersten und zweiten Messwert zu speichern und bei einem folgenden Abschaltvorgang aus zwei der gespeicherten Wertepaare und einem ersten Messwert für den folgenden Abschaltvorgang einen Wert für eine erwartete maximale im Zuge des Abschaltvorgangs über den Halbleiterschalter abfallende Spannung als Bewertungsgröße zu ermitteln. Das kann beispielsweise durch eine lineare Interpolation erfolgen. In einem konkreteren Beispiel werden also Wertepaare aus der Verzugszeit und der gemessenen maximalen Spannung über den Halbleiterschalter gespeichert. Die erwartete maximale Spannung für den folgenden Abschaltvorgang wird dann aus den Wertepaaren und der aktuellen Verzugszeit im folgenden Abschaltvorgang ermittelt.

Die Vorrichtung kann ausgestaltet sein, als Steuermaßnahme ein temporäres Wiedereinschalten des Halbleiterschalters vorzunehmen. Ebenso kann die Vorrichtung ausgestaltet sein, als Steuermaßnahme eine Änderung der Gatespannung vorzunehmen. Weiterhin kann die Vorrichtung ausgestaltet sein, als Steuermaßnahme ein Umschalten auf einen höheren Gatewiderstand vorzunehmen. Die genannten Maßnahmen führen dazu, dass der Kollektor-Strom zumindest für einen kurzen Zeitraum weniger stark absinkt oder sogar wieder steigt. Die Kollektor-Emitter-Spannung steigt dementsprechend weniger stark an oder fällt für den kurzen Zeitraum. Dieser Zeitraum steht für den weiteren Abbau der induktiv gespeicherten Energie zur Verfügung und sorgt damit für eine Verringerung der entstehenden Überspannung, wenn der Halbleiterschalter in der Folge endgültig abgeschaltet wird.

Die Vorrichtung kann ausgestaltet sein, in Abhängigkeit von der Größe des Werts ein Signal an eine übergeordnete Steuerung zu geben. Dadurch wird erreicht, dass die übergeordnete Steuerung des Geräts, von dem der Halbleiterschalter ein Teil ist, also beispielsweise ein Umrichter, reagieren kann. So kann beispielsweise auf den Eingang eines solchen Signals mit einem Notbetrieb reagiert werden.

Die Vorrichtung kann ausgestaltet sein, als Schwellwert der Kollektor-Emitter-Spannung höchstens 10 % der Nennspannung des Halbleiterschalters zu verwenden, insbesondere höchstens 5 %. Wird ein solch kleiner Wert verwendet, endet der Messzeitraum früher und der Wert steht früher zur Verfügung. Der Zeitraum, der für eine Reaktion auf einen möglichen zu hohen Kollektor-Strom bleibt, wird dadurch vergrößert.

Die Vorrichtung kann ausgestaltet sein, den Beginn eines Abschaltvorgangs anhand eines Schwellwerts für die Gatespannung festzulegen. Beispielsweise kann bei einer typischen Beschaltung des Gate-Kontakts ein Unterschreiten einer Gatespannung von 14 V als Trigger verwendet werden, um den Beginn des Abschaltvorgangs festzulegen.

Die Vorrichtung kann ausgestaltet sein, den Beginn eines Abschaltvorgangs anhand eines Steuerbefehls der übergeordneten Steuerung festzulegen.

In einer weiteren Alternative ist die Vorrichtung ausgestaltet, den Beginn eines Abschaltvorgangs anhand des Werts einer Steuerspannung festzulegen, wobei die Steuerspannung ein Spannungswert zwischen einer Endstufe der Treiberschaltung und einem Gatewiderstand ist.

Die Vorrichtung kann ausgestaltet sein, Wertepaare aus dem ersten und zweiten Messwert oder einen daraus gebildeten abgeleiteten Wert für Abschaltvorgänge zu vergleichen, die eine Zeitspanne voneinander getrennt sind, die wenigstens 1 s, insbesondere wenigstens 1 Tag beträgt. Es können also mit anderen Worten die Wertepaare oder beispielsweise der Quotient aus erstem und zweitem Messwert für einen längeren Zeitraum gespeichert werden. Es wird dann ein Vergleich zwischen Werten eines aktuellen Abschaltvorgangs und eines länger zurückliegenden Abschaltvorgangs durchgeführt. In den Vergleich können auch weitere Werte wie beispielsweise die Temperatur des Halbleiterschalters einbezogen werden oder der Vergleich nur für Werte durchgeführt werden, bei denen die Temperatur im Wesentlichen gleich ist. Aus dem Vergleich kann vorteilhaft auf eine Alterung des Halbleiterschalters geschlossen werden, da bei ansonsten gleichen Umgebungsbedingungen ein fester Zusammenhang zwischen der Verzugszeit und der maximalen Überspannung besteht. Dieser Zusammenhang kann mit dem Exemplar des Halbleiterschalters variieren. Dadurch, dass kein absoluter Wert gesucht wird, sondern Werte des jeweiligen Halbleiterschalters miteinander vergleichen werden, spielt die Exemplarstreuung aber keine Rolle.

Die Vorrichtung kann ausgestaltet sein, einen Zeitraum, in dem die Vornahme der Steuermaßnahme möglich ist, mittels einer Verzögerungsschaltung festzulegen. Beispielsweise kann ein Ausgangssignal, das die Steuermaßnahme auslöst, außerhalb dieses Zeitraums durch einen Halbleiterschalter geerdet werden. Der Zeitraum selbst wird anhand eines anderen Signals begonnen und durch eine beispielsweise schaltungstechnisch festgelegte Verzögerung beendet. Diese schaltungstechnisch festgelegte Verzögerung kann beispielsweise durch ein RC-Glied mit nachfolgendem Schmitt-Trigger bestimmt werden.

Alternativ kann die Vorrichtung ausgestaltet sein, einen Zeitraum, in dem die Vornahme der Steuermaßnahme möglich ist, mittels einer Spannungsmessung an einer Z-Diode festzulegen, die mittels eines Spannungsteilers an die Kollektor-Emitter-Spannung angeschlossen ist. Diese Spannungsmessung hat sich in Versuchen als vorteilhaft ergeben, da der Aufbau sehr einfach ist und im Zeitraum des Anstiegs der Kollektor-Emitter-Spannung ein deutlich ausgeprägtes Spannungsplateau erzeugt, durch das der Zeitraum eines sinnvollen Eingriffs in den Abschaltvorgang sehr genau abgegrenzt werden kann.

Die Treiberschaltung bzw. das Verfahren können vorteilhaft in einer Schaltung mit einem Halbleiterschalter wie beispielsweise einem IGBT-Schalter verwendet werden. Die Erfindung ist nicht auf IGBTs beschränkt, sondern kann gleichermaßen bei MOSFETs, insbesondere Silziumkarbid (SiC)-basierten MOSFETs zur Anwendung kommen. In bekannter Weise sind dann Bezugnahmen auf Kollektor als Drain zu verstehen und Bezugnahmen auf Emitter als Source zu verstehen.

Weitere Vorteile und Merkmale sind der folgenden Beschreibung von Ausführungsbeispielen anhand der Figuren zu entnehmen. In den Figuren bezeichnen gleiche Bezugszeichen gleiche Bauteile und Funktionen.

Dabei zeigen:

Figur 1 ein Blockschaltbild eines IGBT mit einer Treiberschaltung und einer mit der Treiberschaltung verbundenen übergeordneten Steuerung,

Figur 2 ein Diagramm mit stark schematisierten Strom- und Spannungsverläufen bei einem Abschaltvorgang des IGBTs,

Figur 3 ein Diagramm mit Messergebnissen zur Kollektor-Emitter-Spannung bei verschiedenen Kollektor-Strömen,

Figur 4 ein Diagramm mit Messdaten zur Abhängigkeit einer Verzugszeit bei der Abschaltung des IGBTs vom Kollektorstrom,

Figur 5 ein Diagramm mit stark schematisierten Spannungsverläufen bei einem Abschaltvorgang des IGBTs,

Figur 6 einen schematischen Ablauf eines Verfahrens zur Ansteuerung des IGBTs,

Figur 7 ein weiteres Diagramm mit Messergebnissen zur Kollektor-Emitter-Spannung bei verschiedenen Kollektor-Strömen.

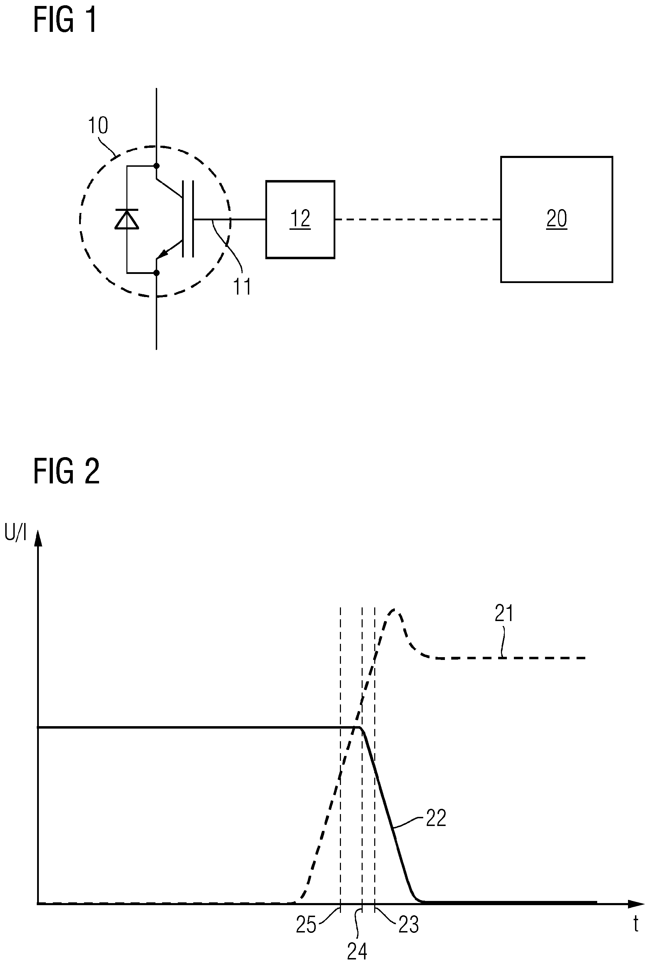

Figur 1 zeigt ein Blockschaltbild eines Schaltungsteils, das einen IGBT 10 umfasst. Der IGBT 10 steht beispielhaft für alle Halbleiterschalter, für die die Erfindung angewendet werden kann. Der IGBT 10 kann Teil einer Schaltung sein, die beispielsweise eine Halbbrücke oder einen Umrichter ausbildet. Der IGBT 10 ist dazu mit weiteren IGBTs oder anderen Halbleiterschaltern verbunden und wird von einer übergeordneten Steuerung 20 angesteuert, um den Zweck der Schaltung zu verwirklichen. Dazu wird der IGBT 10 beispielsweise mit einer Pulsweitenmodulation mit einer Frequenz von 10 kHz geschaltet.

Die hardwarenahe Ansteuerung des IGBTs 10, also die Beaufschlagung seines Gate-Anschlusses 11 mit Spannung und Strom wird von einem Treiber 12 vorgenommen. Der Treiber 12 ist dazu einerseits mit dem Gate-Anschluss 11 des IGBT 10 verbunden und andererseits mit der Steuerung 20. Neben der Umsetzung von Steuersignalen der Steuerung 20 kommt dem Treiber 12 auch die Aufgabe zu, Vorgänge zu steuern, die einen derart schnellen Eingriff erfordern, dass eine Rückmeldung an die Steuerung 20 und ein Abwarten auf Steuersignale von dort zu lange dauern

**EP 4 478 612 A1**

würde. Zu diesen Aufgaben gehört eine Reaktion auf eine mögliche Überspannung, die sich bei einem Abschaltvorgang des IGBT 10 über den IGBT 10 einstellt. Der Grund für eine solche Überspannung liegt in induktiv gespeicherter Energie, die der Stromänderung im Zuge der Abschaltung entgegenwirkt und je nach konkreter Gestaltung der Schaltung, beispielsweise vorhandenen Kapazitäten und Größe der gespeicherten Energie zu höherer oder geringerer Überspannung führt. Überschreitet die über den IGBT 10 anliegende Spannung dessen Sperrfähigkeit, kann das zu seiner Schädigung oder Zerstörung führen.

Ist die Abschaltgeschwindigkeit, d.h. die zeitliche Änderung des Stroms nicht allzu hoch verglichen mit der Zeit, in der sich die induktiv erzeugte Überspannung selbsttätig abbaut, bleibt auch die sich ergebende Überspannung gering. Moderne IGBTs werden jedoch auf immer schnellere Schaltvorgänge hin optimiert, um die auftretenden Schaltverluste zu verringern. Ein pauschales künstliches Verlängern der Abschaltzeit wirkt dieser Verbesserung entgegen und kommt daher normalerweise nicht in Frage. Die Abschaltgeschwindigkeit wird daher in bekannten Treiberschaltungen durch ein situationsabhängiges, kurzes Wiedereinschalten des IGBTs 10 wenn nötig auf Werte begrenzt, die eine schädigende Überspannung vermeiden.

Um situationsabhängig einschalten zu können, muss die sich abzeichnende Überspannung detektiert werden. In bekannten Treiberschaltungen geschieht dies beispielsweise durch die Messung von $dU_{CE}/dt$, also der zeitlichen Änderung der Kollektor-Emitter-Spannung oder $dI_C/dt$, also der zeitlichen Änderung des Kollektor-Stroms. Diese Messungen sind erst möglich, wenn die jeweiligen Änderungen im Zuge des Abschaltvorgangs auftreten und dann auch groß genug sind, um verlässliche Messungen zu erlauben. Das ist erst etwa in der Mitte der Abschaltreaktion, also des tatsächlichen Abfalls des Stroms bzw. des tatsächlichen Anstiegs der Kollektor-Emitter-Spannung möglich. Zu deren Ende hin ergibt sich bereits die Überspannung, sofern eine solche auftritt. Figur 2 zeigt einen stark schematisierten und vereinfachten Abschaltvorgang für einen beliebigen IGBT. Dabei ist der Spannungs-Verlauf 21 der Kollektor-Emitter-Spannung und der Stromverlauf 22 des Kollektor-Stroms gezeigt. Die Überspannung ergibt sich ab dem Zeitpunkt 23, wie am Spannungs-Verlauf 21 erkennbar ist. Eine Messung der Stromänderung $dI_C/dt$ ist zum Zeitpunkt 24 möglich, der nur geringfügig vor dem Einsetzen der Überspannung liegt. Eine Messung der Spannungsänderung $dU_{CE}/dt$ ist zum Zeitpunkt 25 möglich. Der Zeitpunkt 25 liegt noch etwas vor dem Zeitpunkt 24 und gibt demnach noch etwas mehr Zeit bis zum Einsetzen der Überspannung zum Zeitpunkt 23.

Je nach Schaltgeschwindigkeit des betrachteten IGBTs kann die Zeit, die für eine Reaktion verbleibt, also der Abstand zwischen dem Zeitpunkt 23 und einem der Zeitpunkte 24, 25 im Bereich von μs betragen und ausreichend sein, um die Geschwindigkeit der Stromänderung durch eine Schalthandlung des Treiber 12 zu begrenzen. Bei besonders schnellen IGBTs kann die Zeit, die für eine Reaktion verbleibt, aber auch im Bereich von nur noch 100 ns betragen. Diese Zeit ist selbst für den Treiber 12 zu gering für eine Reaktion, da für ein Umsteuern des IGBTs in einem solchen Zeitrahmen selbst die geringen parasitär vorhandenen Induktivitäten zu hoch sind.

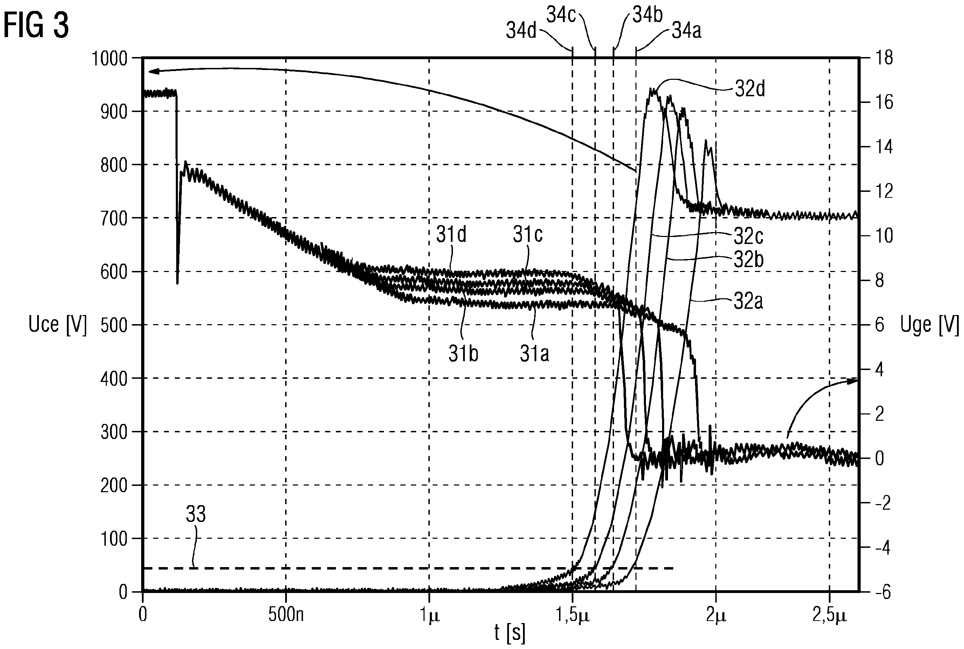

In einem ersten Ausführungsbeispiel für die Erfindung führt der Treiber 12 daher eine veränderte Messung durch. Diese Messung basiert auf der Erkenntnis, dass die Verzugszeit, die sich vom Beginn eines Abschaltvorgangs bis zum Erreichen einer bestimmten Spannungshöhe der Kollektor-Emitter-Spannung erstreckt, von der Höhe des Kollektor-Stroms abhängt. Dieser Zusammenhang ist in Figur 3 verdeutlicht. Figur 3 zeigt eine Messreihe zu Schaltvorgängen eines IGBT bei verschiedenen Werten für den Kollektor-Strom. Die Messkurven 31a...d zeigen den Verlauf der Gate-Emitter-Spannung $U_{GE}$ während eines Abschaltvorgangs, der in etwa 2 μs dauert. Die Messkurve 31a ist bei einem Kollektor-Strom von $I_C$ = 225 A aufgenommen und die Messkurve 31d bei einem Kollektor-Strom von $I_C$ = 850 A. Die zugehörigen Verläufe 32a...d der Kollektor-Emitter-Spannung $U_{CE}$ sind ebenfalls aufgetragen.

Dabei ist erkennbar, dass bei exakter Übereinstimmung des Beginns des Abschaltvorgangs bei ca. t = 100 ns der Anstieg der Kollektor-Emitter-Spannung $U_{CE}$ bei verschiedenen Kollektor-strömen $I_C$ zeitlich verschoben ist. Wird der Zeitpunkt betrachtet, zu dem die Kollektor-Emitter-Spannung $U_{CE}$ einen Schwellwert 33, beispielsweise 50 V erreicht, ergeben sich vier verschiedene Zeitpunkte 34a...d, deren Lage also direkt vom Kollektor-Strom $I_C$ abhängt. Aus dieser zeitlichen Lage lässt sich also der Kollektor-Strom $I_C$ ermitteln. Aus der Höhe des Kollektorstroms wiederum kann darauf geschlossen werden, ob ein Fehler vorliegt und durch einen zu hohen Kollektor-Strom $I_C$ bedingt auch eine zu hohe Überspannung zu erwarten ist.

Vorteilhaft kann hierbei der Schwellwert 33 vergleichsweise gering gewählt werden, beispielsweise nur 20% oder auch nur 10% oder sogar 5% der Nennspannung. Bei einer Messung von $dU_{CE}/dt$ hingegen ist ein brauchbarer Wert erst erreichbar, wenn die Spannung $U_{CE}$ auf etwa die Hälfte der Nennspannung angestiegen ist, also später. Es ergibt sich also durch die Auswertung der Verzugszeit bis zum Erreichen des Schwellwerts 33 eine schnellere Messung und dadurch eine vergrößerte Reaktionszeit für Gegenmaßnahmen.

Die Verzugszeitmessung wird zweckmäßig durch eine Schaltung mit Operationsverstärker umgesetzt. Ein Kondensator wird aufgeladen und behält so lange seine Ladung, bis der Spannungswert über einen Analog-Digital-Wandler an einen im Treiber 12 verwendeten Mikrokontroller übermittelt wurde.

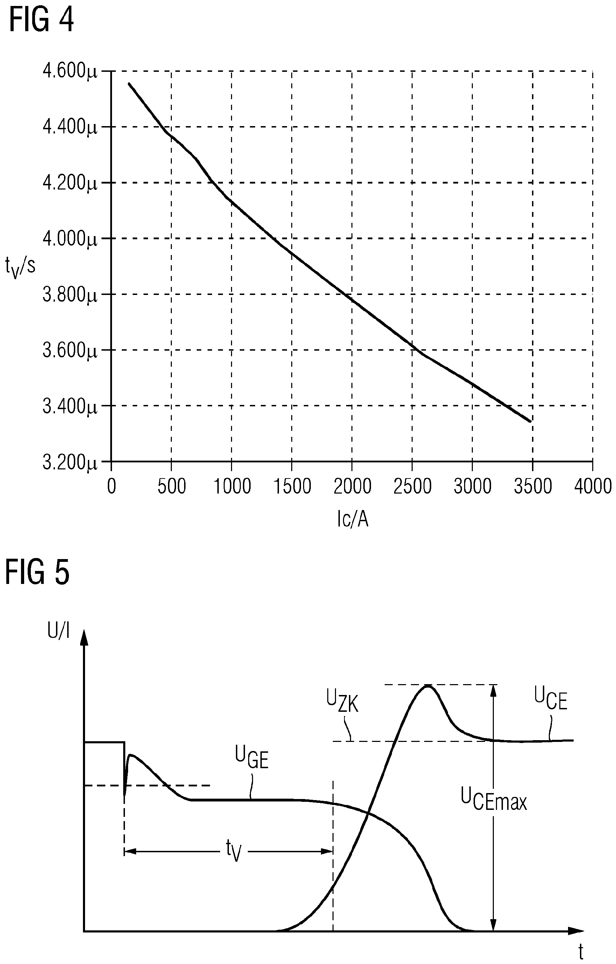

Figur 4 zeigt den Zusammenhang zwischen den sich ergebenden Verzugszeiten $t_V$ und dem Kollektorstrom $I_C$ bei Abschaltung für einen beispielhaften 3,3 kV IGBT. Wie schon aus Figur 3 ersichtlich, fällt die Verzugszeit $t_V$ bei steigendem Kollektorstrom $I_C$. Allerdings ist dieser Graph wie auch die in Figur 3 gezeigten Verläufe einer Exemplarstreuung unterworfen und würde für zwei konkrete IGBTs nicht exakt übereinstimmen. Weiterhin besteht eine deutliche Abhängigkeit der Verzugszeit $t_V$ von der Temperatur des IGBT.

Der Treiber 12 ist nun so ausgestaltet, dass zusätzlich zur Messung der Verzugszeit $t_V$ auch eine Messung der maximalen während des Abschaltvorgangs über den IGBT 10 auftretenden Spannung $U_{CEmax}$ vorgenommen wird. Die beiden Werte sind in Figur 5 anhand des Verlaufs von Gatespannung $U_{GE}$ und Kollektor-Emitter-Spannung $U_{CE}$ für einen Abschaltvorgang veranschaulicht. Hierbei liegen stets Überspannungen vor, d.h. die maximale Spannung ist stets etwas höher als die letztlich anliegende stationäre Spannung, die im realen Einsatz beispielsweise eine Zwischenkreisspannung $U_{ZK}$ ist. In Figur 3 beträgt die Zwischenkreisspannung 700 V. Wie ebenfalls aus Figur 3 erkennbar ist, steigt die auftretende Überspannung mit dem Kollektorstrom $I_c$ an.

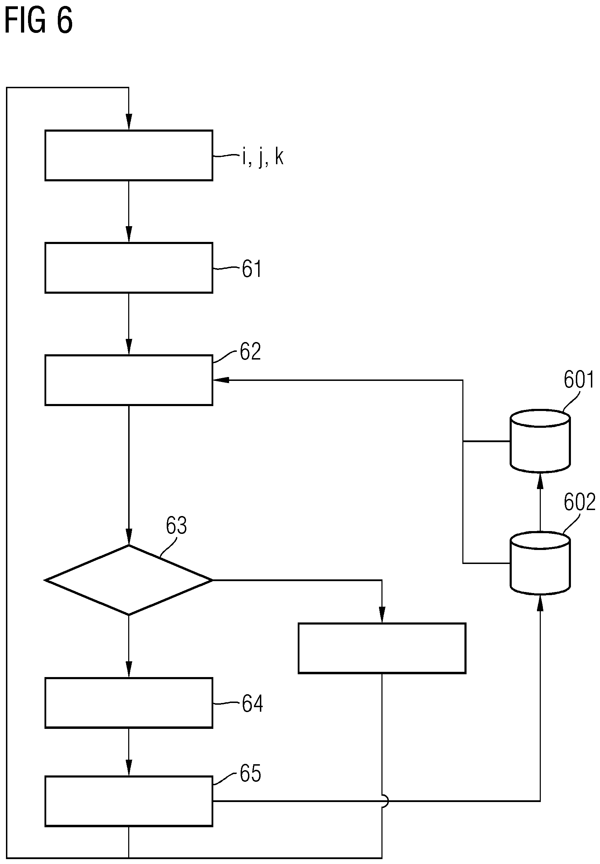

Das vom Treiber durchgeführte Verfahren ist schematisch in Figur 6 dargestellt. Das verwendete Verfahren ist dabei weitgehend zyklisch und wird also weitgehend für jeden Abschaltvorgang i, j, k durchgeführt. Zu Beginn eines beispielhaften Abschaltvorgangs k wird in einem ersten Schritt 61 die Verzugszeit $t_{Vk}$ gemessen.

Bei einem Abschaltvorgang i ergibt sich aus der ermittelten Verzugszeit $t_{Vi}$ und der ermittelten maximalen Spannung $U_{CEmax,i}$ ein Wertepaar ($t_{Vi}$, $U_{CEmax,i}$). Wenigstens zwei solcher Wertepaare ($t_{Vi}$, $U_{CEmax,i}$) und ($t_{Vj}$, $U_{CEmax,j}$) für zwei Abschaltvorgänge sind in Speicherorten 601, 602 gespeichert. Diese werden regelmäßig im Zuge von späteren Schritten des Verfahrens gemäß Figur 6 überschrieben und werden daher hier als vorhanden vorausgesetzt. Dabei können die Abschaltvorgänge i, j aufeinander folgende Abschaltvorgänge sein, die beiden Abschaltvorgänge i, j können aber auch durch andere Abschaltvorgänge voneinander getrennt sein.

In dem aktuell betrachteten Abschaltvorgang k wird nun in einem zweiten Schritt 62 aus der Verzugszeit $t_{Vk}$ rechnerisch auf die nun zu erwartende maximale Spannung $U_{max,k}$ geschlossen. Dies geschieht durch lineare Extrapolation. Dazu werden die folgenden Berechnungen ausgeführt:

$$\Delta t_{V1} = t_{Vj} - t_{Vi}$$

$$\Delta t_{V2} = t_{Vk} - t_{Vi}$$

$$\Delta U_1 = U_{CEmax,j} - U_{CEmax,i}$$

$$U_{max,k} = U_{CEmax,i} + \Delta U_1 \cdot \Delta t_{V2} / \Delta t_{V1}$$

Es versteht sich, dass ein Teil dieser Berechnungen schon vorab nach Aufnahme der Werte für die zurückliegenden Abschaltvorgänge i, j stattfinden kann. Insbesondere kann der Quotient $\Delta U_1 / \Delta t_{V1}$ bereits nach Aufnahme der entsprechenden Werte, also schon vor dem Abschaltvorgang k ermittelt werden, so dass beim Abschaltvorgang k nur die Multiplikation mit $\Delta t_{V2}$ und die Summierung zu tun verbleibt.

Da als Schwellwert für das Ende der Verzugszeit $t_V$ ein Wert für die Kollektor-Emitter-Spannung von beispielsweise 50 V verwendet wird, steht zu einem verhältnismäßig frühen Zeitpunkt nun ein extrapolierter Wert für die zu erwartende Überspannung $U_{max,k}$ im aktuell stattfindenden Abschaltvorgang k zur Verfügung.

Dieser extrapolierte Wert ist vorteilhaft nicht durch eine absolute Umrechnung aus den vorhandenen Daten ermittelt, sondern wird nur aus kurz vorher bestimmten Messwerten errechnet. Der Wert ist dadurch völlig unabhängig von jeglicher Exemplar-Streuung des verwendeten Schaltertyps, da diese Einflüsse auch Teil der Messwerte sind, aus denen $U_{max,k}$ bestimmt wird.

Der Wert für die maximale Spannung $U_{max,k}$ ist weiterhin auch unabhängig von der Temperatur des IGBT 10, wenn die für die Extrapolation verwendeten Wertepaare und damit die Abschaltvorgänge i, j zeitlich nicht zu weit zurückliegen. Da aber mit Frequenzen von 10 kHz oder mehr geschaltet wird, liegen die vorangehenden Abschaltvorgänge im Idealfall nur im Bereich von wenigen 100 $\mu s$ zurück. Bei höheren Schaltfrequenzen sind die Abstände sogar entsprechend geringer. Eine erhebliche Temperaturänderung des Schalters ist in solchen Zeiträumen nicht zu erwarten. Da somit die Werte für die Abschaltvorgänge i, j bei derselben oder nahezu derselben Temperatur bestimmt wurden, spielt auch die absolute Temperatur des IGBT 10 keine Rolle für die Ermittlung der maximalen Spannung $U_{m-ax,k}$.

Es kann somit anhand des bestimmten Wertes für die zu erwartende maximale Spannung $U_{max,k}$ direkt im Treiber 12 erkannt werden, ob diese die Spannungsfestigkeit $U_S$ des verwendeten Schalters überschreitet. Neben einem Vergleich mit der Spannungsfestigkeit $U_S$ des IGBT 10 kann auch ein Vergleich mit einem anderen Schwellwert für die maximale Spannung $U_{max,k}$ durchgeführt werden. Beispielsweise kann aus Sicherheitsgründen ein Schwellwert $U_{SD}$ verwendet werden, der um einige Prozent unterhalb der Spannungsfestigkeit liegt, also beispielsweise $U_{SD} = U_S \cdot 0{,}96$.

Es wird also in einem dritten Schritt 63 nun ein Vergleich der errechneten maximalen Spannung $U_{max,k}$ mit dem Schwellwert vorgenommen. Überschreitet die erwartete maximale Spannung $U_{max,k}$ den Schwellwert $U_{SD}$ nicht, dann ist ein Eingreifen in den Abschaltvorgang unnötig, da der Abschaltvorgang zu keiner gefährlichen Überspannung führt. In diesem Fall wird das Verfahren mit dem vierten Schritt 64 fortgesetzt. Im vieren Schritt 64 wird die tatsächlich erreichte maximale Kollektor-Emitter-Spannung $U_{CEmax,k}$ des IGBT 10 für den Abschaltvorgang k gemessen. Diese Messung beruht wiederum darauf, dass mit Hilfe einer Verstärker-Schaltung ein Kondensator geladen wird, dessen Spannung über einen Analog-Digital-Wandler an den Mikrokontroller übermittelt wird. Da der gemessene Wert für die maximale Spannung vor einem folgenden Abschaltvorgang, also vor dem Ablauf weiterer 100 μs nicht zwingend benötigt wird, besteht für diese Messung keine besondere Eile.

In einem fünfen Schritt 65 wird das Wertepaar aus der Verzugszeit $t_{Vk}$ und der maximalen Kollektor-Emitter-Spannung $U_{CE\text{-}max,k}$ des IGBT 10 in einem der beiden Speicherorte 601, 602 gespeichert. Dabei wird typischerweise ein vorher vorhandenes Wertepaar überschrieben, sofern schon eines vorhanden war. Es versteht sich, dass für die ersten Abschaltvorgänge keine Wertepaare vorliegen und somit auch der zweite Schritt nicht ausgeführt werden kann. Um stets aktuelle Wertepaare in den Speicherorten 601, 602 vorliegen zu haben, die Speicherung zwischen diesen beiden Speicherorten 601, 602 alternieren oder bei der Speicherung zuerst das Wertepaar aus dem zweiten Speicherort 602 in den ersten Speicherort 601 verschoben werden, bevor das neu gemessene Wertepaar in den zweiten Speicherort geschrieben wird.

Es gibt auch alternative Ausführungsformen, bei denen nicht unbedingt Wertepaare von zwei aufeinander folgenden Abschaltvorgängen gespeichert werden. Beispielsweise kann über die Speicherung eines Zählers für die Abschaltvorgänge dafür gesorgt werden, dass die gespeicherten Wertepaare von Abschaltvorgängen stammen, die durch einen oder mehrere, beispielsweise fünf andere Abschaltvorgänge voneinander getrennt sind. Dadurch kann vorteilhaft die Genauigkeit der Extrapolation gesteigert werden, da dann zu erwarten ist, dass $\Delta t_{V1}$ und $\Delta U_1$ dem Betrag nach größer sind, also mit anderen Worten größere Unterschiede in den gemessenen Werten der beiden Abschaltvorgänge i, j vorliegen.

Nach dem fünften Schritt wird das Verfahren beim nächsten Abschaltvorgang i, j, k fortgesetzt und beginnt sodann wieder mit dem ersten Schritt 61 für den dann vorliegenden Abschaltvorgang.

Ergibt der Vergleich im dritten Schritt 63, das die erwartete maximale Spannung $U_{max,k}$ den Schwellwert $U_{SD}$ überschreitet, dann wird in einem sechsten Schritt 66 ein Eingriff in den Abschaltvorgang veranlasst. Ein solcher Eingriff beinhaltet in einer Ausgestaltung ein Wiedereinschalten des IGBT 10 für einen eng begrenzten Zeitraum. Dieses Wiedereinschalten sorgt dafür, dass der induktiv getriebene Strom kurzfristig am Schalter nicht mehr blockiert ist und sich die aufgebaute Spannung wieder abbauen kann. Es versteht sich, dass dieses Wiedereinschalten nach kurzer Zeit wieder beendet werden muss.

In einer alternativen Ausgestaltung kann auch ein der Stärke nach begrenztes Wiedereinschalten passieren, bei dem die Gatespannung $U_{GE}$ des IGBT 10 so gesteuert wird, dass der IGBT 10 nur begrenzt leitfähig wird. Auch dieses Wiedereinschalten muss zeitlich so eng begrenzt wir möglich stattfinden, um die dadurch entstehenden elektrischen Verluste möglichst gering zu halten.

Da durch den Eingriff in den Abschaltvorgang die tatsächlich auftretende maximale Kollektor-Emitter-Spannung $U_{CEmax,k}$ verfälscht wird und somit eine Extrapolation aus diesen Werten falsch wäre, wird im Falle eines Eingriffs keine Speicherung in den Speicherorten 601, 602 vorgenommen. Stattdessen wird auch der gemessene Wert für die Verzugszeit für diesen Abschaltvorgang verworfen. Das Verfahren wird dann beim nächsten Abschaltvorgang wieder aufgenommen.

Durch die Extrapolation ist bekannt, wie weit die erwartete maximale Spannung $U_{max,k}$ den Schwellwert überschreitet. Dadurch kann die Stärke des Eingriffs, d.h. seine Dauer und/oder der Wert für die Gatespannung an die erwartete Überspannung angepasst werden. Somit kann die Erzeugung zusätzlicher elektrischer Verluste auf das nötige Minimum zum Schutz des IGBTs 10 reduziert werden.

Ist eine Steuerung des Eingriffs aus der Extrapolation nicht notwendig, beispielsweise wenn die Dauer des Eingriffs anderweitig festgelegt wird, dann kann es zur Vereinfachung des Verfahrens auch reichen, aus dem Schwellwert $U_{SD}$ für die maximale Spannung und den gespeicherten Wertepaaren einen Schwellwert $t_{SD}$ für die Verzugszeit $t_V$ zu errechnen. Wird der Schwellwert $t_{SD}$ für die Verzugszeit im Abschaltvorgang k unterschritten, also $t_{Vk} < t_{SD}$, dann ist zu erwarten, dass die maximale entstehende Spannung den Schwellwert $U_{SD}$ für die Spannung überschreitet.

Aus den Formeln für die Extrapolation wird dabei:

$$U_{SD} = U_{CEmax,i} + \Delta U_1 \cdot (t_{SD} - t_{Vi}) / \Delta t_{V1}$$

$$t_{SD} = t_{Vi} + (U_{SD} - U_{CEmax,i}) \cdot \Delta t_{V1} / \Delta U_1$$

$t_{SD}$ kann somit aus den zwei gespeicherten Wertepaaren bestimmt werden. Die Extrapolation im Abschaltvorgang k im zweiten Schritt 62 entfällt und wird durch den einfacheren Vergleich der Verzugszeiten $t_{Vk}$, $t_{SD}$ im dritten Schritt ersetzt.

Mit der Verzugszeit $t_V$ wird eine Größe ermittelt, die beeinflusst ist vom Kollektorstrom $I_C$, aber diesem nicht entspricht, weil sie noch durch andere erhebliche Einflussgrößen mitbestimmt wird. Eine zur Verzugszeit $t_V$ alternative solche Größe, die sich bei Messungen an IGBTs herausgestellt hat, ist der Gatestrom $I_G$.

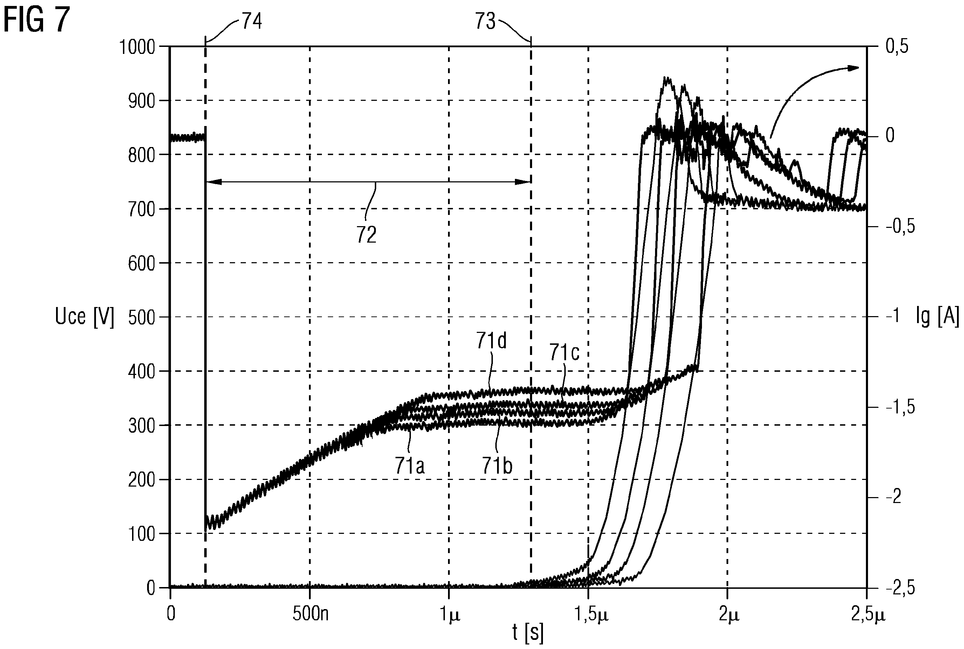

In einem zweiten Ausführungsbeispiel für die Erfindung führt der Treiber 12 daher eine alternative Messung durch. Diese Messung basiert auf der Erkenntnis, dass die Höhe des Gatestroms $I_G$, die sich nach dem Ablauf einer Messzeit 72 nach Beginn eines Abschaltvorgangs ergibt, von der Höhe des Kollektor-Stroms $I_C$ abhängt. Dieser Zusammenhang ist in Figur 7 verdeutlicht. Figur 7 zeigt eine Messreihe zu Schaltvorgängen eines IGBT 10 bei verschiedenen Werten für den Kollektor-Strom $I_C$. Die Messkurven 71a...d zeigen den Verlauf des Gate-Stroms $I_G$ während eines Abschaltvorgangs, der in etwa 2 µs dauert. Die Messkurve 71a ist bei einem Kollektor-Strom von $I_C$ = 225 A aufgenommen und die Messkurve 71d bei einem Kollektor-Strom von $I_C$ = 850 A. Die zugehörigen Verläufe 32a...d der Kollektor-Emitter-Spannung $U_{CE}$ sind ebenfalls aufgetragen.

Zur realen Bestimmung des Gatestroms wird in einem Messzeitraum, auch Messfenster genannt, eine Integration des an einem Shunt-Widerstand gemessenen Stroms durchgeführt, also eine Ladungsmenge bestimmt. Dieses Messfenster wird an den verwendeten IGBT-Typ angepasst. Beispielsweise kann das Messfenster einen Zeitraum von 200 ns bis 300 ns nach dem Beginn des Abschaltvorgangs umfassen.

Der konkrete Zeitpunkt 73, zu dem die Messung durchgeführt wird, ergibt sich, indem nach dem Beginn des Abschaltvorgangs zum Zeitpunkt 74 die Messzeit verstreicht. In Figur 7 ist erkennbar, dass zu Anfang des Abschaltvorgangs die Verläufe 71a...d des Gate-Stroms noch nicht unterscheidbar sind, aber nach Ablauf der Messzeit zum Zeitpunkt 73 eine klare Abhängigkeit vom Kollektor-Strom $I_C$ besteht.

Der Gatestrom $I_G$ wird in der Folge in den Schritten 62, 65 des Verfahrens analog zur Verzugszeit $t_V$ verwendet. Die genannten Vorteile dieser Vorgehensweise gelten ebenso für den Gatestrom $I_G$ wie für die Verzugszeit $t_V$.

Wie bereits ausgeführt, hat die beschriebene Vorgehensweise mehrere Vorteile. Die Abschätzung der zu erwartenden maximalen Kollektor-Emitter-Spannung und damit auch der Überspannung erlaubt es, im Normalbetrieb, also abseits von Kurzschlüssen o.ä., sehr früh zu entscheiden, ob in den Abschaltvorgang eingegriffen werden muss und zusätzlich auch, wie stark in den Abschaltvorgang eingegriffen werden muss.

Weiterhin ist diese Abschätzung unabhängig von Chargenstreuung, Bauteilstreuung und Temperatur des Schalters, da die Abschätzung nur kurz vorher gemessene Werte verwendet. Sie funktioniert daher ohne Kalibrierung und erfordert nur das Festlegen von wenigen Schwellwerten. Der Schwellwert für das Ende der Verzugszeitmessung kann sehr grob festgelegt werden, beispielsweise auf 50 V. Der Schwellwert für die erlaubte maximale Spannung hängt direkt mit der Spannungsfestigkeit des Schalters zusammen und benötigt anderweitig keine Kalibrierung. Es kann also in sehr einfacher Weise eine kalibrierfreie Optimierung der Abschaltvorgänge im Normalbetrieb stattfinden.

Während die Wertepaare, die in den Speicherorten 602, 602 gespeichert werden, zweckmäßig sehr aktuell sein sollten, also regelmäßig überschrieben werden, ist es vorteilhaft, eine Auswahl dieser Wertepaare längerfristig zu speichern. Dies kann im Treiber 12 oder andernorts geschehen. Die Wertepaare können dabei kombiniert werden mit anderen Messwerten, die zur Verfügung stehen.

In einem Ausführungsbeispiel wird jede Minute ein solches Wertepaar in einer Datenbank hinterlegt zusammen mit Werten für die Temperatur des IGBT 10 und der aktuellen Leistung eines Stromrichters, in dem der IGBT 10 verwendet wird. Unter Berücksichtigung aller zu einem Zeitpunkt gespeicherten Werte wird ein Vergleich des Verhältnisses von Verzugszeit $t_V$ und maximaler Kollektor-Emitter-Spannung $U_{CEmax}$ durchgeführt werden. Eine Veränderung dieses Verhältnisses bei gleichen anderweitigen Betriebsdaten gibt einen Hinweis auf eine Alterung des IGBT 10. Somit kann unter Verwendung der so gespeicherten Daten ein permanentes Monitoring durchgeführt werden. So können Servicezeitpunkte (beispielsweise Reinigung der Luftkühler) und Ausfallzeitpunkte (beispielsweise durch Alterung der AVT: Bonddrahtabhebungen) besser ermittelt werden.

Bezugszeichenliste

| | |
|---|---|
| 10 | IGBT |
| 11 | Gate-Anschluss |
| 12 | Treiberschaltung |
| 20 | übergeordnete Steuerung |
| 21 | Verlauf der Kollektor-Emitter-Spannung |
| 22 | Verlauf des Kollektor-Stroms |
| 23 | Zeitpunkt des Auftretens einer Überspannung |
| 24 | Zeitpunkt der $dI_C$/dt-Messung |
| 25 | Zeitpunkt der $dU_{CE}$/dt-Messung |
| 31a...d | Verlauf der Gate-Emitter-Spannung |
| 32a...d | Verlauf der Kollektor-Emitter-Spannung |

| 33 | Schwellwert |
|---|---|
| 34a...d | Zeitpunkte |
| 71a...d | Verlauf des Gate-Stroms |
| 72 | Messzeit |
| 73 | Zeitpunkt |
| 74 | Beginn des Abschaltvorgangs |
| $U_{ZK}$ | Zwischenkreisspannung |
| $U_{GE}$ | Gate-Emitter-Spannung |
| $t_V$ | Verzugszeit |
| $U_{CE}$ | Kollektor-Emitter-Spannung, Spannung über den Halbleiterschalter |
| $U_{CEmax}$ | maximale Spannung über den Halbleiterschalter |
| i, j, k | Abschaltvorgang |
| 61...65 | erster bis fünfter Schritt |
| 601, 602 | Speicherort |

## Patentansprüche

1. Treiberschaltung (12) zur Ansteuerung eines Halbleiterschalters (10), umfassend einen Kontakt zur Verbindung mit einem Steueranschluss (11) des Halbleiterschalters (10) und eine Vorrichtung, die ausgestaltet ist, im Zuge eines Abschaltvorgangs (i, j, k) des Halbleiterschalters (10) eine Messung eines von der Höhe des durch den Halbleiterschalter (10) fließenden Stroms abhängigen ersten Messwerts ($t_V$) vorzunehmen, wobei der Wert entweder

   - die Höhe des Gatestroms (71a...d) zu einem Zeitpunkt (72) oder in einem Zeitfenster nach Beginn (74) des Abschaltvorgangs (i, j, k) oder
   - eine Zeitspanne vom Beginn (74) des Abschaltvorgangs (i, j, k) bis zum Erreichen eines festlegbaren Schwellwerts (33) der über den Halbleiterschalter (10) abfallenden Spannung ($U_{CE}$) ist,
   **dadurch gekennzeichnet, dass** die Vorrichtung ausgestaltet ist,
   - einen zweiten Messwert für eine im Zuge des Abschaltvorgangs auftretende maximale über den Halbleiterschalter (10) abfallende Spannung ($U_{CEmax}$) aufzunehmen,
   - für einen folgenden Abschaltvorgang (k) mit dem ersten und zweiten Messwert ($t_V$, $U_{CEmax}$) eine Bewertungsgröße zu ermitteln,
   - basierend auf der Bewertungsgröße eine Steuermaßnahme zur Verringerung der zeitlichen Änderung des durch den Halbleiterschalter (10) fließenden Stroms vorzunehmen.

2. Treiberschaltung (12) nach Anspruch 1, bei der die Vorrichtung ausgestaltet ist, für zwei oder mehr, insbesondere aufeinanderfolgende, Abschaltvorgänge (i, j) Wertepaare aus einem jeweiligen ersten und zweiten Messwert ($t_V$, $U_{CEmax}$) zu speichern und bei einem folgenden Abschaltvorgang (k) aus zwei der gespeicherten Wertepaare und einem ersten Messwert ($t_V$) für den folgenden Abschaltvorgang (k) einen Wert für eine erwartete maximale im Zuge des Abschaltvorgangs über den Halbleiterschalter (10) abfallende Spannung als Bewertungsgröße zu ermitteln.

3. Treiberschaltung (12) nach einem der vorangehenden Ansprüche, bei der die Vorrichtung ausgestaltet ist, als Steuermaßnahme ein temporäres Wiedereinschalten des Halbleiterschalters (10) vorzunehmen.

4. Treiberschaltung (12) nach einem der vorangehenden Ansprüche, bei der die Vorrichtung ausgestaltet ist, als Steuermaßnahme eine Änderung der Gatespannung ($U_{GE}$) vorzunehmen.

5. Treiberschaltung (12) nach einem der vorangehenden Ansprüche, bei der die Vorrichtung ausgestaltet ist, als Steuermaßnahme ein Umschalten auf einen höheren Gatewiderstand vorzunehmen.

6. Treiberschaltung (12) nach einem der vorangehenden Ansprüche, bei der die Vorrichtung ausgestaltet ist, in Abhängigkeit von der Bewertungsgröße ein Signal an eine übergeordnete Steuerung (20) zu geben.

7. Treiberschaltung (12) nach einem der vorangehenden Ansprüche, bei der die Vorrichtung ausgestaltet ist, als Schwellwert (33) der Kollektor-Emitter-Spannung ($U_{CE}$) höchstens 10% der Nennspannung des Halbleiterschalters (10) zu verwenden.

8. Treiberschaltung (12) nach einem der vorangehenden Ansprüche, bei der die Vorrichtung ausgestaltet ist, den Beginn (74) eines Abschaltvorgangs (i, j, k) anhand eines Schwellwerts für die Gatespannung ($U_{GE}$) festzulegen.

9. Treiberschaltung (12) nach einem der vorangehenden Ansprüche, bei der die Vorrichtung ausgestaltet ist, den Beginn (74) eines Abschaltvorgangs (i, j, k) anhand eines Steuerbefehls der übergeordneten Steuerung (20) festzulegen.

10. Treiberschaltung (12) nach einem der vorangehenden Ansprüche, bei der die Vorrichtung ausgestaltet ist, den Beginn eines Abschaltvorgangs (i, j, k) anhand des Werts einer Steuerspannung festzulegen, wobei die Steuerspannung ein Spannungswert zwischen einer Endstufe der Treiberschaltung (12) und einem Gatewiderstand ist.

11. Treiberschaltung (12) nach einem der vorangehenden Ansprüche, bei der die Vorrichtung ausgestaltet ist, einen Zeitraum, in dem die Vornahme der Steuermaßnahme möglich ist, mittels einer Spannungsmessung an einer Z-Diode festzulegen, die mittels eines Spannungsteilers an die Kollektor-Emitter-Spannung ($U_{CE}$) angeschlossen ist.

12. Treiberschaltung (12) nach einem der vorangehenden Ansprüche, bei der die Vorrichtung ausgestaltet ist, Wertepaare aus dem ersten und zweiten Messwert ($t_V$, $U_{CEMax}$) oder einen daraus gebildeten abgeleiteten Wert für Abschaltvorgänge zu vergleichen, die eine Zeitspanne voneinander getrennt sind, die wenigstens 1 s, insbesondere wenigstens 1 Tag beträgt.

13. Halbleiterschalter (10), insbesondere IGBT (10), MOSFET oder SiC-basierter MOSFET, mit einer Treiberschaltung (12) nach einem der vorangehenden Ansprüche.

14. Verfahren zur Ansteuerung eines Halbleiterschalters (10), bei dem im Zuge eines Abschaltvorgangs (i, j, k) des Halbleiterschalters (10) eine Bestimmung eines ersten Messwerts für einen von der Höhe des durch den Schalter fließenden Stroms abhängigen Wert vorgenommen wird, wobei der erste Messwert entweder die Höhe des Gatestroms (71a...d) zu einem Zeitpunkt (72) nach Beginn (74) des Abschaltvorgangs (i, j, k) oder eine Zeitspanne vom Beginn (74) des Abschaltvorgangs (i, j, k) bis zum Erreichen eines festlegbaren Schwellwerts (33) der über den Schalter abfallenden Spannung ($U_{CE}$) ist, **dadurch gekennzeichnet, dass** ein zweiter Messwert ($U_{CEmax}$) für eine im Zuge des Abschaltvorgangs (i, j, k) auftretende maximale über den Halbleiterschalter (10) abfallende Spannung ($U_{CEmax}$) aufgenommen wird, für einen folgenden Abschaltvorgang (k) mit dem ersten und zweiten Messwert ($t_V$, $U_{CEmax}$) eine Bewertungsgröße ermittelt wird und basierend auf der Bewertungsgröße eine Steuermaßnahme zur Verringerung der zeitlichen Änderung des durch den Halbleiterschalter (10) fließenden Stroms vorgenommen wird.

# FIG 1

# FIG 2

FIG 3

FIG 4

FIG 5

# FIG 6

FIG 7

EP 4 478 612 A1

Europäisches Patentamt
European Patent Office
Office européen des brevets

# EUROPÄISCHER RECHERCHENBERICHT

Nummer der Anmeldung

EP 23 17 9501

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 4 044 436 A1 (SIEMENS AG [DE]) 17. August 2022 (2022-08-17) * Abbildungen 1, 3 * * Ansprüche 1-5,8-11,13 * ----- | 1-14 | INV. H03K17/0812 H03K17/082 H03K17/16 |
| A | EP 1 348 256 B1 (CT CONCEPT TECHNOLOGIE AG [CH]) 9. Juli 2008 (2008-07-09) * Abbildung 2c * ----- | 1-14 | |

RECHERCHIERTE SACHGEBIETE (IPC)

H03K

Der vorliegende Recherchenbericht wurde für alle Patentansprüche erstellt

| Recherchenort | Abschlußdatum der Recherche | Prüfer |
|---|---|---|
| Den Haag | 14. November 2023 | Simon, Volker |

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 23 17 9501

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-11-2023

| Im Recherchenbericht angeführtes Patentdokument | Datum der Veröffentlichung | Mitglied(er) der Patentfamilie | | Datum der Veröffentlichung |
|---|---|---|---|---|
| EP 4044436 A1 | 17-08-2022 | CN | 116964938 A | 27-10-2023 |
| | | EP | 4044436 A1 | 17-08-2022 |
| | | EP | 4264832 A1 | 25-10-2023 |
| | | WO | 2022174948 A1 | 25-08-2022 |
| EP 1348256 B1 | 09-07-2008 | AT | E400924 T1 | 15-07-2008 |
| | | EP | 1348256 A1 | 01-10-2003 |
| | | ES | 2304997 T3 | 01-11-2008 |
| | | JP | 4764592 B2 | 07-09-2011 |
| | | JP | 2004516767 A | 03-06-2004 |
| | | US | 2004056646 A1 | 25-03-2004 |
| | | WO | 02052726 A1 | 04-07-2002 |

Für nähere Einzelheiten zu diesem Anhang : siehe Amtsblatt des Europäischen Patentamts, Nr.12/82

EPO FORM P0461